# EUROPÄISCHE PATENTANMELDUNG

(11) **EP 4 145 664 A1**
(43) Veröffentlichungstag der Anmeldung: **08.03.2023**
(21) Anmeldenummer: 21195249.4
(22) Anmeldetag: 07.09.2021
(51) Int. Cl.: H02J 7/00

(54) **LADEVERFAHREN FÜR EIN BATTERIEPACK EINER ELEKTRISCHEN HANDWERKZEUGMASCHINE**

(71) Anmelder: HILTI Aktiengesellschaft, 9494 Schaan (LI)
(72) Erfinder: Stanger, Robert, 87600 Kaufbeuren (DE)
(74) Vertreter: Hilti Aktiengesellschaft Corporate Intellectual Property

(57) **Zusammenfassung**

Batteriezellen-Ladeverfahren zum Laden einer Lithiumionen-Batteriezelle eines Batteriepacks einer elektrischen Handwerkzeugmaschine, bei dem ein der Lithiumionen-Batteriezelle zur Verfügung gestellte Ladestrom auf Basis eines die Lithiumionen-Batteriezelle charakterisierenden Zellzustands eingestellt wird, wobei der die Lithiumionen-Batteriezelle charakterisierende Zellzustand ein Gesundheitszustand und/oder ein Innenwiderstand der Lithiumionen-Batteriezelle ist.

## Beschreibung

Die vorliegende Erfindung betrifft ein Batteriezellen-Ladeverfahren zum Laden einer Lithiumionen-Batteriezelle eines Batteriepacks einer elektrischen Handwerkzeugmaschine. Bei dem Batteriezellen-Ladeverfahren wird ein der Lithiumionen-Batteriezelle zur Verfügung gestellte Ladestrom auf Basis eines die Lithiumionen-Batteriezelle charakterisierenden Zellzustands eingestellt. Batteriezellen-Ladeverfahren, die anhand eines Temperatur-Zellzustands der Lithiumionen-Batteriezelle eines Batteriepacks gesteuert werden, sind grundsätzlich aus dem Stand der Technik bekannt.

EP 2 276 139 B1 beschreibt ein Batteriezellen-Ladeverfahren zum Laden einer Lithiumionen-Batteriezelle, wobei das Batteriezellen-Ladeverfahren ein Anlegen einer variablen Ladespannung und eines variablen Stroms an die Batteriezelle abhängig von einem kontinuierlich variablen Spannungs-Ladeprofil umfasst, wobei das kontinuierlich variable Spannungs-Ladeprofil in Abhängigkeit von einem Imaginärwiderstand bestimmt wird, der in Reihe mit einem Widerstand eines Gleichstrommodells der Batteriezelle ist.

US 8,116, 998 B2 offenbart ein Verfahren zum Bestimmten eines Gesundheitszustands einer Batteriezelle, um festzustellen, ob die Batteriezelle defekt ist.

Es ist Aufgabe der vorliegenden Erfindung ein Batteriezellen-Ladeverfahren zum Laden einer Lithiumionen-Batteriezelle einer elektrischen Handwerkzeugmaschine anzugeben, welches die Grundlage für eine erhöhte Lebensdauer des Lithiumionen-Batteriepacks und die Grundlage für eine Ladezeitverkürzung schafft.

Die Aufgabe wird dadurch gelöst, dass der die Lithiumionen-Batteriezelle charakterisierende Zellzustand ein Gesundheitszustand (SoH) und/oder ein Innenwiderstand (DCR) der Lithiumionen-Batteriezelle ist.

Die Erfindung schließt die Erkenntnis ein, dass ein temperaturbasiertes Laden eines Lithiumionen-Batteriepacks einer elektrischen Handwerkzeugmaschine nur ungenaue, nicht auf den Gesundheitszustand (SoH) der Lithiumionen-Batteriezelle abgestimmte Ladeströme ermöglicht. Dadurch sind die Ladezeiten bei Lithiumionen-Batteriezellen mit gutem SoH länger als nötig. Bei Lithiumionen-Batteriezellen mit schlechtem SoH schreitet die Alterung schneller voran, da die Ladeströme ggf. zu hoch sind und die Lithiumionen-Batteriezellen schädigen.

Es wurde weiterhin erkannt, dass der Gesundheitszustand (SoH) der Lithiumionen-Batteriezellen als direkt proportional zum Widerstand (DCR) der Lithiumionen-Batteriezelle angenommen werden kann. Somit ist es möglich, den Ladestrom nach erfolgter DCR Bestimmung an den jeweiligen SoH anzupassen. Somit kann bei einer Lithiumionen-Batteriezelle mit gutem Gesundheitszustand (dies entspricht einem vergleichsweise geringem Innenwiderstand DCR) einerseits der Ladeström erhöht werden, was die Ladezeiten verkürzt. Andererseits kann bei einer gealterten Lithiumionen-Batteriezelle (dies entspricht einem vergleichsweise hohen Innenwiderstand DCR) der Ladestrom reduziert werden, was eine Alterung der Lithiumionen-Batteriezelle verlangsamt und somit die Lebensdauer erhöht.

In einer besonders bevorzugten Ausgestaltung des Verfahrens wird der Innenwiderstand Lithiumionen-Batteriezelle gemessen und/oder bestimmt. Dazu kann eine Leerlaufspannung der Lithiumionen-Batteriezelle ohne Belastung und/oder eine Arbeitsspannung der mit einem vorgegebenen Widerstand belasteten Lithiumionen-Batteriezelle gemessen werden.

Es hat sich als vorteilhaft herausgestellt, wenn beim Überschreiten einer vorbestimmten Innenwiderstandsschwelle ein niedrigerer als der vorangehende Ladestrom eingestellt wird. Alternativ oder zusätzlich kann beim Unterschreiten einer vorbestimmten Innenwiderstandsschwelle ein höherer als der vorangehende Ladestrom eingestellt werden. Es hat sich als vorteilhaft herausgestellt, wenn wenigstens zwei, vorzugsweise drei Innenwiderstandsschwellen vorgesehen sind.

In einer besonders bevorzugten Ausgestaltung des Verfahrens wird der Ladestrom in diskreten Stufen, vorzugsweise ausschließlich in diskreten Stufen eingestellt. Es hat sich als vorteilhaft herausgestellt, wenn wenigstens drei, vorzugsweise vier diskrete und voneinander verschiedene Ladeströme vorgesehen sind. In einer weiteren besonders bevorzugten Ausgestaltung wird der am Ende eines jeweiligen Ladevorgangs bestimmte Innenwiderstand abgespeichert.

In einer besonders bevorzugten Ausgestaltung des Verfahrens, kann der der Batteriepack eine Mehrzahl von Lithiumionen-Batteriezellen aufweisen. Es hat sich als vorteilhaft herausgestellt, wenn der zur Verfügung gestellte Ladestrom auf Basis eines gemittelten Innenwiderstands der Mehrzahl von Lithiumionen-Batteriezellen eingestellt wird. Es hat sich ebenfalls als vorteilhaft herausgestellt, wenn eine Leerlaufspannung (Gleichspannung) des Batteriepack weniger als 60 Volt beträgt und vorzugsweise 12 Volt, 22 Volt oder 36 Volt beträgt.

In einer weiteren bevorzugten Ausgestaltung kann vorgesehen sein, dass der Innenwiderstand der Lithiumionen-Batteriezelle, insbesondere vor dem Festlegen eines Ladestroms, mit einem Temperatur-Zellzustand der Lithiumionen-Batteriezelle gewichtet wird. So kann der Innenwiderstand beispielsweise mit einem Kehrwert der Zelltemperatur (oder einem vielfachen des Kehrwerts) multipliziert werden. Der Kehrwert kann diskretisiert sein. Es ist denkbar den Ladestrom mittels einer Lookup-Tabelle vorzugeben. In einer anderen besonders bevorzugten Ausgestaltung des Verfahrens wird ein Temperatur-Zellzustand der Lithiumionen-Batteriezelle lediglich für eine Notabschaltung des Ladevorgangs verwendet.

Die Aufgabe wird ebenfalls gelöst durch ein Batteriezellen-Ladesystem zum Laden einer Lithiumionen-Batteriezelle eines Batteriepacks einer elektrischen Handwerkzeugmaschine, wobei das Batteriezellen-Ladesystem einen Ladecontroller aufweist, der eingerichtet ist, ein der Lithiumionen-Batteriezelle zur Verfügung gestellten Ladestrom auf Basis eines die Lithiumionen-Batteriezelle charakterisierenden Zellzustands einzustellen. Der die Lithiumionen-Batteriezelle charakterisierende Zellzustand ist ein Gesundheitszustand und/oder ein Innenwiderstand der Lithiumionen-Batteriezelle. Es hat sich als vorteilhaft herausgestellt, wenn der Ladecontroller in dem Batteriepack angeordnet ist. Alternativ kann der Ladecontroller von einer Ladestation des Batteriezellen-Ladesystems umfasst sein. Das Batteriezellen-Ladesystem kann durch die mit Bezug auf das Batteriezellen-Ladeverfahren verwendeten Merkmale in entsprechender Weise weitergebildet sein.

Weitere Vorteile ergeben sich aus der folgenden Figurenbeschreibung. In den Figuren sind besonders bevorzugte Ausführungsbeispiel der vorliegenden Erfindung dargestellt. Die Figuren, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

In den Figuren sind gleiche und gleichartige Komponenten mit gleichen Bezugszeichen beziffert. Es zeigen
Figur 1 ein bevorzugtes Ausführungsbeispiel eines Batteriezellen-Ladeverfahren; und
Figur 2 ein bevorzugtes Ausführungsbeispiel eines Batteriezellen-Ladesystems.

### Ausführunasbeispiele:

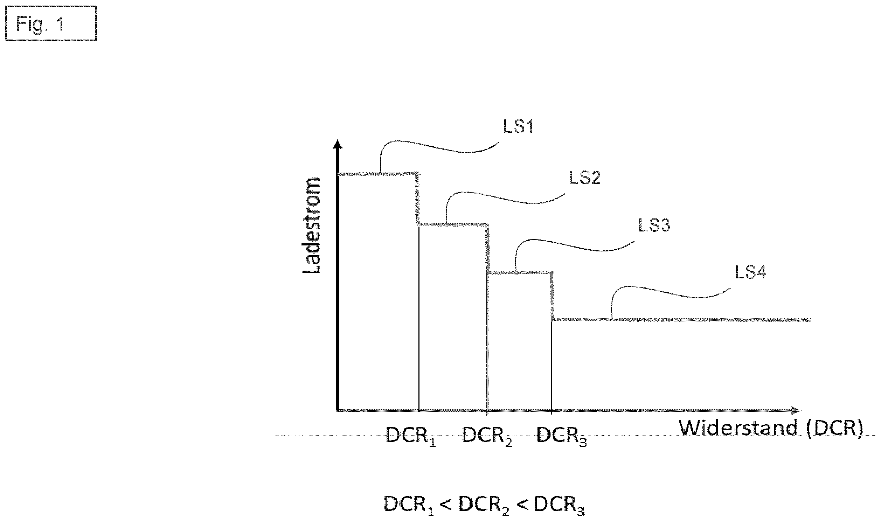

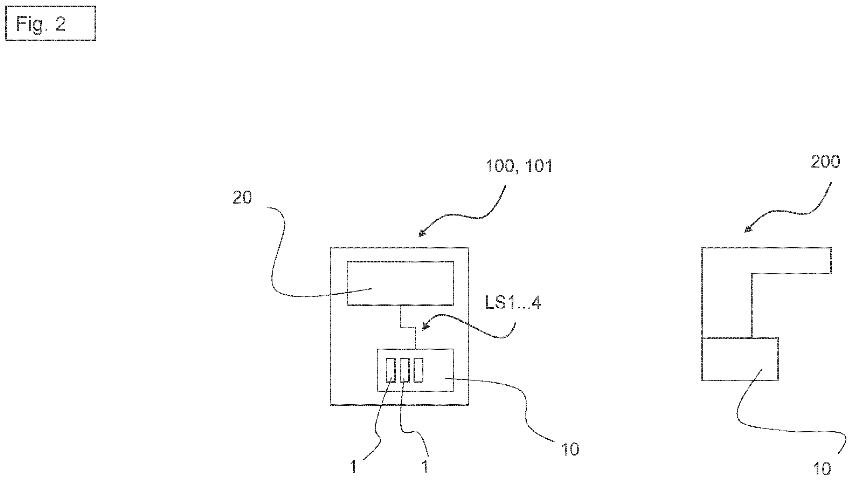

Ein bevorzugtes Ausführungsbeispiel eines Batteriezellen-Ladeverfahrens soll mit Bezug auf das in Fig. 1 gezeigte schematisierte Diagrammform erläutert werden. Das Batteriezellen-Ladeverfahren kommt vorzugsweise zum Laden einer Lithiumionen-Batteriezelle eines Batteriepacks 10 (vgl. Fig. 2) einer elektrischen Handwerkzeugmaschine zum Einsatz. Im Diagramm in Fig. 1 der an die Lithiumionen-Batteriezelle gelieferte Ladestrom (Ordinate) über dem momentanen Innenwiderstand der Lithiumionen-Batteriezelle DCR (Abszisse) aufgetragen.

Im Rahmen des erfindungsgemäßen Verfahrens ist vorgesehen, dass der der Lithiumionen-Batteriezelle zur Verfügung gestellte Ladestrom auf Basis des Innenwiderstands DCR (der den Gesundheitszustand SoH repräsentiert) eingestellt wird. Im Rahmen des Verfahrens wird der Innenwiderstand DCR der Lithiumionen-Batteriezelle gemessen. Dies kann kontinuierlich erfolgen oder am Beginn eines jeweiligen Ladevorgangs. Alternativ oder zusätzlich kann Innenwiderstand DCR aus einem Speicher ausgelesen werden. Vorteilhaft ist vorgesehen, dass der am Ende eines jeweiligen Ladevorgangs bestimmte Innenwiderstand abgespeichert wird.

Im gesunden Neuzustand weist die Lithiumionen-Batteriezelle 1 (vgl. Fig. 2) beispielhaft einen Innenwiderstand DCR auf, der unterhalb einer ersten Innenwiderstandsschwelle DCR1 liegt. Die erste Innenwiderstandsschwelle DCR1 beträgt beispielhaft 0,1 Ohm. Die Lithiumionen-Batteriezelle wird mit einem ersten Ladestrom LS1 aufgeladen. Der ersten Ladestrom LS1 beträgt beispielhaft konstant 4 Ampere.

Nach mehreren Ladevorgängen kann die Lithiumionen-Batteriezelle beispielhaft einen Innenwiderstand DCR aufweisen, der zwischen der ersten Innenwiderstandsschwelle DCR1 und einer zweiten Innenwiderstandsschwelle DCR2 liegt. Die zweite Innenwiderstandsschwelle DCR2 beträgt beispielhaft 0,2 Ohm. Die Lithiumionen-Batteriezelle ist somit gealtert. Die Lithiumionen-Batteriezelle wird nun mit einem zweiten Ladestrom LS2 aufgeladen. Der zweite Ladestrom LS2 ist geringer als der erste Ladestrom LS1 und beträgt beispielhaft konstant 3 Ampere.

Nach weiteren Ladevorgängen kann die Lithiumionen-Batteriezelle beispielhaft einen Innenwiderstand DCR aufweisen, der zwischen der zweiten Innenwiderstandsschwelle DCR2 und einer dritten Innenwiderstandsschwelle DCR3 liegt. Die dritte Innenwiderstandsschwelle DCR3 beträgt beispielhaft 0,3 Ohm. Die Lithiumionen-Batteriezelle wird nun mit einem dritten Ladestrom LS3 aufgeladen. Der dritte Ladestrom LS3 ist geringer als der zweite Ladestrom LS2 und beträgt beispielhaft konstant 2 Ampere.

Nahe Ihres Lebenszeitendes kann die Lithiumionen-Batteriezelle beispielhaft einen Innenwiderstand DCR aufweisen, der über der dritten Innenwiderstandsschwelle DCR3 liegt. In diesem Fall wird die Lithiumionen-Batteriezelle von nun an mit einem vierten Ladestrom LS4 aufgeladen, der beispielhaft konstant 1 Ampere beträgt. Das eben beschriebene verdeutlicht, dass beim Überschreiten einer vorbestimmten Innenwiderstandsschwelle jeweils niedriger Ladestrom in diskreten Stufen (beispielhaft von jeweils 1 Ampere) eingestellt wird.

Es ist grundsätzlich denkbar, dass aufgrund von Selbstorganisationsprozessen innerhalb der Lithiumionen-Batteriezelle deren Innenwiderstand DCR steigt. Für diesen Fall kann vorgesehen sein, dass beim Unterschreiten einer vorbestimmten Innenwiderstandsschwelle ein höherer Ladestrom eingestellt wird.

Fig. 2 zeigt - in stark schematisierter Form - ein bevorzugtes Ausführungsbeispiel eines Batteriezellen-Ladesystems 100. Das Batteriezellen-Ladesystem 100 dient zum Laden einer Lithiumionen-Batteriezelle 1 eines Batteriepacks 10 einer elektrischen Handwerkzeugmaschine 200. Das Batteriezellen-Ladesystem 100 weist einen Ladecontroller 20 auf, der eingerichtet ist, ein der Lithiumionen-Batteriezelle 1 zur Verfügung gestellten Ladestrom LS1...4 auf Basis eines die Lithiumionen-Batteriezelle 1 charakterisierenden Zellzustands, nämlich eines Innenwiderstands DCR der Lithiumionen-Batteriezelle 1, einzustellen. Dazu ist der Ladecontroller 20 eingerichtet, dass mit Bezug auf Figur 1 beschriebene Batteriezellen-Ladeverfahren auszuführen.

Der Ladecontroller 20 ist beispielhaft von einer Ladestation 101, die vorliegend das Batteriezellen-Ladesystem 100 bildet, umfasst.

### Bezugszeichenliste

- 1: Lithiumionen-Batteriezelle
- 10: Batteriepack
- 20: Controller
- 100: Batteriezellen-Ladesystem
- 101: Ladestation
- 200: Elektrische Handwerkzeugmaschine

- SoH: Gesundheitszustand
- DCR: Innenwiderstand
- DCR1: erste Innenwiderstandsschwelle
- DCR2: zweite Innenwiderstandsschwelle
- DCR3: dritte Innenwiderstandsschwelle
- LS1: erster Ladestrom
- LS2: zweiter Ladestrom
- LS3: dritter Ladestrom
- LS4: vierter Ladestrom

## Patentansprüche

1. Batteriezellen-Ladeverfahren zum Laden einer Lithiumionen-Batteriezelle eines Batteriepacks einer elektrischen Handwerkzeugmaschine, bei dem ein der Lithiumionen-Batteriezelle zur Verfügung gestellte Ladestrom auf Basis eines die Lithiumionen-Batteriezelle charakterisierenden Zellzustands eingestellt wird,
**dadurch gekennzeichnet, dass** der die Lithiumionen-Batteriezelle charakterisierende Zellzustand ein Gesundheitszustand (SoH) und/oder ein Innenwiderstand (DCR) der Lithiumionen-Batteriezelle ist.

2. Batteriezellen-Ladeverfahren nach Anspruch 1,
**dadurch gekennzeichnet, dass** im Rahmen des Verfahrens der Innenwiderstand (DCR) der Lithiumionen-Batteriezelle gemessen wird.

3. Batteriezellen-Ladeverfahren nach Anspruch 1 oder 2,
**dadurch gekennzeichnet, dass** beim Überschreiten einer vorbestimmten Innenwiderstandsschwelle (DCR1, DCR2, DCR3) ein niedrigerer Ladestrom eingestellt wird.

4. Batteriezellen-Ladeverfahren nach einem der vorangehenden Ansprüche,
**dadurch gekennzeichnet, dass** beim Unterschreiten einer vorbestimmten Innenwiderstandsschwelle (DCR1, DCR2, DCR3) ein höherer Ladestrom eingestellt wird.

5. Batteriezellen-Ladeverfahren nach einem der vorangehenden Ansprüche,
**dadurch gekennzeichnet, dass** der Ladestrom ausschließlich in diskreten Stufen eingestellt wird.

6. Batteriezellen-Ladeverfahren nach einem der vorangehenden Ansprüche,
**dadurch gekennzeichnet, dass** der am Ende eines jeweiligen Ladevorgangs bestimmte Innenwiderstand abgespeichert wird.

7. Batteriezellen-Ladeverfahren nach einem der vorangehenden Ansprüche,
**dadurch gekennzeichnet, dass** der Batteriepack eine Mehrzahl von Lithiumionen-Batteriezellen aufweist, wobei der zur Verfügung gestellte Ladestrom auf Basis eines gemittelten Innenwiderstands der Mehrzahl von Lithiumionen-Batteriezellen eingestellt wird.

8. Batteriezellen-Ladeverfahren nach einem der vorangehenden Ansprüche,
**dadurch gekennzeichnet, dass** der Innenwiderstand (DCR) der Lithiumionen-Batteriezelle mit einem Temperatur-Zellzustand der Lithiumionen-Batteriezelle gewichtet wird.

9. Batteriezellen-Ladeverfahren nach einem der Ansprüche 1 bis 7,
**dadurch gekennzeichnet, dass** ein Temperatur-Zellzustand der Lithiumionen-Batteriezelle lediglich für eine Notabschaltung des Ladevorgangs verwendet wird.

10. Batteriezellen-Ladesystem (100) zum Laden einer Lithiumionen-Batteriezelle (1) eines Batteriepacks (10) einer elektrischen Handwerkzeugmaschine (200), wobei das Batteriezellen-Ladesystem (100) einen Ladecontroller (20) aufweist, der eingerichtet ist, ein der Lithiumionen-Batteriezelle (1) zur Verfügung gestellten Ladestrom (LS1...4) auf Basis eines die Lithiumionen-Batteriezelle (1) charakterisierenden Zellzustands einzustellen, wobei der die Lithiumionen-Batteriezelle (1) charakterisierende Zellzustand ein Gesundheitszustand (SoH) und/oder ein Innenwiderstand (DCR1...3) der Lithiumionen-Batteriezelle (1) ist.

11. Batteriezellen- Ladesystem nach Anspruch 10,
**dadurch gekennzeichnet, dass** der Ladecontroller (20) in dem Batteriepack (10) angeordnet ist, oder von einer Ladestation (101) des Batteriezellen-Ladesystems (100) umfasst ist.
